# EUROPEAN PATENT APPLICATION

(11) **EP 1 968 105 A2**
(43) Date of publication of application: **10.09.2008**
(21) Application number: 07255072.6
(22) Date of filing: 28.12.2007
(51) Int. Cl.: H01L 21/336, H01L 21/77

(54) **Thin film transistor, method of fabricating the same, and organic light emitting diode display device including the same**

(30) Priority: 28.12.2006 KR 20060136779
(71) Applicant: Samsung SDI Co., Ltd., Suwon-si, Gyeonggi-do (KR)
(72) Inventor: Seo, Jin Wook, Suwon-si Gyeonggi-do (KR); Park, Byoung-Keon, Suwon-si Gyeonggi-do (KR); Yang, Tae-Hoon, Suwon-si Gyeonggi-do (KR); Lee, Ki-Yong, Suwon-si Gyeonggi-do (KR)
(74) Representative: Mounteney, Simon James

(57) **Abstract**

A thin film transistor includes: a substrate; a semiconductor layer disposed on the substrate, including a source region, a drain region and a channel region, and made of a polycrystalline silicon layer; a gate electrode disposed to correspond to the channel region of the semiconductor layer; a gate insulating layer disposed between the semiconductor layer and the gate electrode; and source and drain electrodes electrically connected to the source and drain regions of the semiconductor layer, respectively, wherein the polycrystalline silicon layer comprises a plurality of regions having different Raman spectrum peaks from each other.

## Description

### BACKGROUND OF THE INVENTION

### 1. Field of the Invention

Aspects of the present invention relate to a thin film transistor, a method of fabricating the same, and an organic light emitting diode(OLED) display device including the same. More particularly, aspects of the present invention relate to a thin film transistor having a polycrystalline silicon layer with a specific Raman spectrum peak in a Super Grain Silicon (SGS) crystallization method of forming a capping layer, forming a crystallization inducing metal layer and crystallizing an amorphous silicon layer into a polycrystalline silicon layer, a method of fabricating the same, and an OLED display device including the same

### 2. Description of the Related Art

In general, a polycrystalline silicon layer has a high field effect mobility, can be applied to a high speed operating circuit, and can be easily used to fabricate a CMOS circuit. Therefore, polycrystalline layers are widely used in forming semiconductor layers of thin film transistors. A thin film transistor using such a polycrystalline silicon layer may be used as an active device of an active matrix liquid crystal display (AMLCD) or a switching device or a driving device of an active matrix OLED display device.

For forming a polycrystalline silicon layer used in a thin film transistor, an evaporation method, a technique using high annealing, or a laser annealing method may be used. The laser annealing method can be performed at a low temperature and can provide a polycrystalline silicon layer having high field effect mobility. However, the laser annealing method requires an expensive laser apparatus, and therefore, alternative techniques are being developed.

Currently, much research is being conducted on methods of crystallizing amorphous silicon layers using a crystallization inducing metal. A method using a crystallization inducing metal has an advantage of allowing crystallization to be performed in a shorter time at a lower temperature than a Solid Phase Crystallization (SPC) method. Types of crystallization using a metal include Metal Induced Crystallization (MIC) and Metal Induced Lateral Crystallization (MILC). However, these crystallization methods using a metal may cause the device characteristics of the thin film transistor to deteriorate due to contamination of the metal.

Meanwhile, in order to form a polycrystalline silicon layer having good quality while reducing the amount of the metal, a technique has been proposed that forms a polycrystalline silicon layer having good quality using high annealing, rapid thermal annealing (RTA), or laser irradiation by adjusting an ion concentration of the metal by means of an ion injecting device. Also, in order to make the surface of the polycrystalline silicon layer planarized using MIC, a method has been proposed that mixes a viscous organic layer with a liquid metal, deposits a thin film using a spin-coating method, and then anneals the same to induce crystallization.

However, even in these crystallization methods, there are still problems in terms of uniformity of the grain size and in making the grain size bigger, which are the most important factors in the polycrystalline silicon layer. To solve such problems, a method of fabricating a polycrystalline silicon layer has been proposed as a crystallization method using a capping layer. The method includes depositing an amorphous silicon layer on a substrate, forming a capping layer on the amorphous silicon layer, forming a crystallization inducing metal layer on the capping layer, and diffusing a crystallization inducing metal into the amorphous silicon layer through the capping layer by an annealing process to form a seed, thereby obtaining the polycrystalline silicon layer.

This method has an advantage of preventing the crystallization inducing metal from being contaminated more than required because the metal is diffused through the capping layer. However, with this method, a large amount of metal still remains in the polycrystalline silicon layer. Also, it may be difficult to determine whether a sufficient amount of crystallization inducing metal is present for crystallizing the amorphous silicon layer into the polycrystalline silicon layer to form a thin film transistor, whether a sufficient amount of seed is formed, and whether an annealing process is performed for a long enough time for the crystallization.

### SUMMARY OF THE INVENTION

Aspects of the present invention provide a method of crystallizing an amorphous silicon layer into a polycrystalline silicon layer by SGS crystallization, which defines, with Raman spectrum peaks in a specific range, crystal grains of the polycrystalline silicon layer in a seed region, a grain boundary region, and a crystal growth region disposed between the seed region and the grain boundary region.

According to a first aspect of the present invention, a thin film transistor comprises: a substrate; a semiconductor layer disposed on the substrate, including a source region, a drain region and a channel region, and made of a polycrystalline silicon layer; a gate electrode disposed to correspond to a predetermined region of the semiconductor layer; a gate insulating layer disposed between the semiconductor layer and the gate electrode; and source and drain electrodes electrically connected to the source and drain regions of the semiconductor layer, respectively, wherein the polycrystalline silicon layer comprises a plurality of regions having different Raman spectrum peaks from each other.

Preferred features of this aspect of the invention are set out in Claims 2 to 7.

According to a second aspect of the present invention, a method of fabricating a thin film transistor comprises: preparing a substrate; forming an amorphous silicon layer on the substrate; forming a capping layer on the amorphous silicon layer; forming a crystallization inducing metal layer on the capping layer; annealing the substrate, diffusing the crystallization inducing metal onto the amorphous silicon layer through the capping layer, and crystallizing the amorphous silicon layer into a polycrystalline silicon layer composed of a plurality of regions having different Raman spectrum peaks from each other; removing the capping layer and the crystallization inducing metal layer; patterning the polycrystalline silicon layer to form a semiconductor layer; forming a gate insulating layer on the semiconductor layer; forming a gate electrode on the gate insulating layer; forming an interlayer insulating layer on the gate electrode; and etching the interlayer insulating layer and the gate insulating layer, and forming source and drain electrodes electrically connected to predetermined regions of the semiconductor layer.

Preferred features of this aspect of the invention are set out in Claims 9 to 15.

According to a third aspect of the present invention, an OLED display device comprises the features of Claim 16.

Additional aspects and/or advantages of the invention will be set forth in part in the description which follows and, in part, will be obvious from the description, or may be learned by practice of the invention.

### BRIEF DESCRIPTION OF THE DRAWINGS

Embodiments of the present invention will be described by way of example and with reference to the attached drawings in which:
FIGS. 1A to 1D are cross-sectional views illustrating an SGS crystallization method according to an embodiment of the present invention;
FIG. 2A is a Scanning Electron Microscope (SEM) photograph showing crystal grains of a polycrystalline silicon layer formed by the SGS method shown in FIG. 1;
FIGS. 2B to 2D are Raman spectrum graphs illustrating differences in crystallinity according to internal positions of the crystal grains shown in FIG. 2A;
FIGS. 3A to 3D are cross-sectional views illustrating a process of fabricating a thin film transistor using a polycrystalline silicon layer fabricated according to an embodiment of the present invention; and
FIG. 4 is a cross-sectional view of an OLED display device according to an embodiment of the present invention.

### DETAILED DESCRIPTION OF THE EMBODIMENTS

Reference will now be made in detail to the present embodiments of the present invention, examples of which are illustrated in the accompanying drawings, wherein like reference numerals refer to the like elements throughout. The embodiments are described below in order to explain the present invention by referring to the figures.

Aspects of the invention may be embodied in different forms and should not be construed as limited to the embodiments set forth herein. Rather, these embodiments are provided so that this disclosure will be thorough and complete, and will fully convey the scope of the invention to those skilled in the art. In the drawings, the thickness of layers and regions are exaggerated for clarity. In addition, when a layer is described as being formed on another layer or on a substrate, the layer may be formed directly on the other layer or on the substrate, or a third layer may be interposed between the layer and the other layer or the substrate.

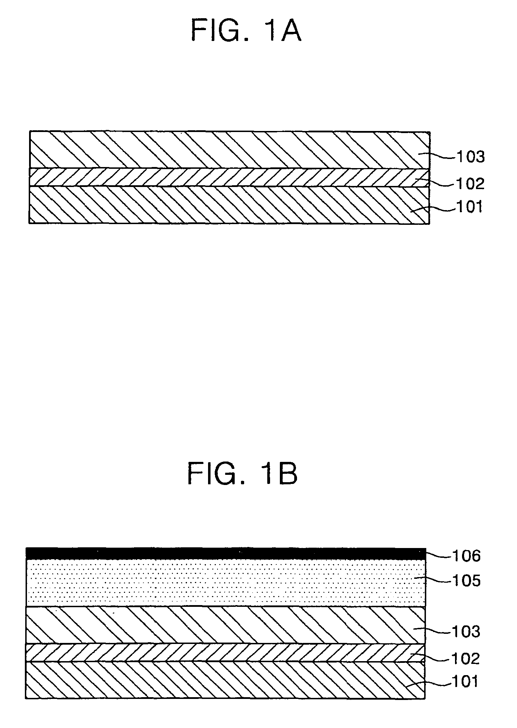

FIGS. 1A to 1D are cross-sectional views illustrating a crystallization process according to an embodiment of the present invention. As shown in FIG. 1A, a buffer layer 102 is formed on a substrate 101 formed of glass or plastic. The buffer layer 102 may be formed as a single layer or as a double layer including an insulating layer such as a silicon oxide layer or a silicon nitride layer and may be formed using a chemical vapor deposition (CVD) method or a physical vapor deposition (PVD) method. The buffer layer 102 acts to prevent diffusion of moisture or impurities generated from the substrate 101 or acts to adjust the transfer rate of heat during crystallization so that the crystallization of the amorphous silicon layer can be properly performed.

Subsequently, an amorphous silicon layer 103 is formed on the buffer layer 102. The amorphous silicon layer 103 may be formed by CVD or PVD. Also, during or after the formation of the amorphous silicon layer 103, a process of dehydrogenating the amorphous silicon layer may be performed to reduce the hydrogen concentration.

FIG. 1B is a cross-sectional view illustrating a process of forming a capping layer and a crystallization inducing metal layer on the amorphous silicon layer. Referring to FIG. 1B, a capping layer 105 is formed on the amorphous silicon layer 103. As a non-limiting example, the capping layer 105 may be formed of silicon nitride, which allows a crystallization inducing metal formed in a subsequent process to be diffused during an annealing process. Alternatively, the capping layer may be formed as a double layer including a silicon nitride layer and a silicon oxide layer. The capping layer 105 is formed by a method such as a CVD method, a PVD method, or the like. Here, the capping layer 105 has a thickness of 1Å to 2000Å.

Subsequently, a crystallization inducing metal is deposited on the capping layer 105 to form a crystallization inducing metal layer 106. The crystallization inducing metal may be at least one material selected from the group consisting of Ni, Pd, Ti, Ag, Au, Al, Sn, Sb, Cu, Co, Mo, Tr, Ru, Rh, Cd, and Pt. As a specific, non-limiting example, the crystallization inducing metal may be Ni. The crystallization inducing metal layer 106 is formed with a surface density of 10¹¹ atoms/cm² to 10¹⁵ atoms/cm² on the capping layer 105. When the crystallization inducing metal has a surface density less than 10¹¹ atoms/cm², the amount of seed as a nucleus of crystallization is small so that it is difficult to crystallize the amorphous silicon layer into a polycrystalline silicon layer. When the crystallization inducing metal has a surface density greater than 10¹⁵ atoms/cm², the amount of crystallization inducing metal diffusing into the amorphous silicon layer is large so that the crystal grains of the polycrystalline silicon layer are small. Also, the amount crystallization inducing metal that remains in the polycrystalline silicon layer is larger so that characteristics of a semiconductor layer to be formed by patterning the polycrystalline silicon layer are worse.

In general, the thickness or density of the crystallization inducing metal should be carefully adjusted in the conventional MIC or MILC method. This is because the crystallization inducing metal remains on a surface of the polycrystalline silicon layer after crystallization and can cause problems such as an increase in leakage current of the thin film transistor. However, in accordance with aspects of the present invention, the crystallization inducing metal layer may be formed without accurately controlling the thickness or density. This is because the capping layer 105 controls the diffusing crystallization inducing metal to cause only a small amount of crystallization inducing metal to be diffused into the amorphous silicon layer to contribute to crystallization. Most of the crystallization inducing metal of the crystallization inducing metal layer does not penetrate the capping layer 105 and does not contribute to crystallization.

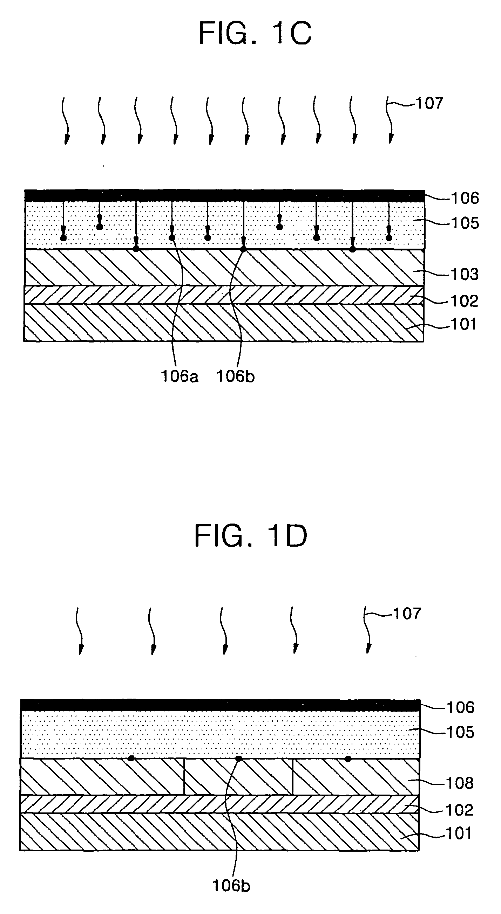

FIG. 1C is a cross-sectional view illustrating a process of annealing the substrate to cause a crystallization inducing metal to be diffused into an interface of an amorphous silicon layer through a capping layer. Referring to FIG. 1C, the substrate 101 where the buffer layer 102, the amorphous silicon layer 103, the capping layer 105, and the crystallization inducing metal layer 106 are formed is subjected to an annealing process 107 to move some of crystallization inducing metal of the crystallization inducing metal layer 106 to a surface of the amorphous silicon layer 103. Only a small amount of the crystallization inducing metal that diffuses through the capping layer 105 makes it all the way to the surface of the amorphous silicon layer 103. Most of the crystallization inducing metal does not penetrate the capping layer 105 or does not reach all the way to the amorphous silicon layer 103. (Crystallization inducing metal that reaches the surface of the amorphous silicon layer 103 is identified in FIG. 1C and 1D by the reference numeral "106b" and crystallization inducing metal that penetrates the capping layer but does not reach the surface of the amorphous silicon layer 103 is identified in FIG. 1C by the reference numeral "106a.")

Accordingly, the amount of crystallization inducing metal reaching the surface of the amorphous silicon layer 103 is determined by the diffusion suppressing ability of the capping layer 105. The diffusion suppressing ability of the capping layer 105 has a close relationship with the thickness of the capping layer 105. That is, as the thickness of the capping layer 105 is increases, the amount of the diffused crystallization inducing metal decreases so that the size of crystal grains subsequently produced in the amorphous silicon layer 103 is larger. As the thickness of the capping layer 105 decreases, the amount of the diffused crystallization inducing metal increases so that the size of the crystal grains subsequently produced in the amorphous silicon layer 103 is smaller.

The annealing process 107 is performed for several seconds to several hours at a temperature of 200°C to 900°C to diffuse the crystallization inducing metal, and may be conducted by a furnace process, an RTA process, a UV process, or a laser process.

FIG. 1D is a cross-sectional view illustrating a process of crystallizing an amorphous silicon layer into a polycrystalline silicon layer due to the diffused crystallization inducing metal. Referring to FIG. 1D, the amorphous silicon layer 103 is crystallized into a polycrystalline silicon layer 108 as induced by the crystallization inducing metal 106b that has diffused through the capping layer 105 onto the surface of the amorphous silicon layer 103. That is, the diffused crystallization inducing metal 106b combines with silicon of the amorphous silicon layer to form a metal silicide, and the metal silicide forms a seed as a nucleus of the crystallization so that the amorphous silicon layer is crystallized into the polycrystalline silicon layer.

The crystallization method according to aspects of the present invention includes forming a capping layer on an amorphous silicon layer, forming a crystallization inducing metal layer on the capping layer, annealing to diffuse the crystallization inducing metal, and crystallizing the amorphous silicon layer into a polycrystalline silicon layer using the diffused crystallization inducing metal, which method is referred to as an SGS crystallization method.

Therefore, when the amount of the metal silicide as a nucleus of the crystallization, i.e., the amount of the crystallization inducing metal 106b is adjusted, the crystal grain size of the polycrystalline silicon layer 108 can be adjusted.

As described above, the annealing process 107 may be performed without removing the capping layer 105 and the crystallization inducing metal layer 106 in FIG. 1D. However, it is also possible to diffuse the crystallization inducing metal onto the amorphous silicon layer to form metal silicide as a nucleus of the crystallization, remove the capping layer 105 and the metal catalyst layer 106, and perform annealing thereon to form a polycrystalline silicon layer.

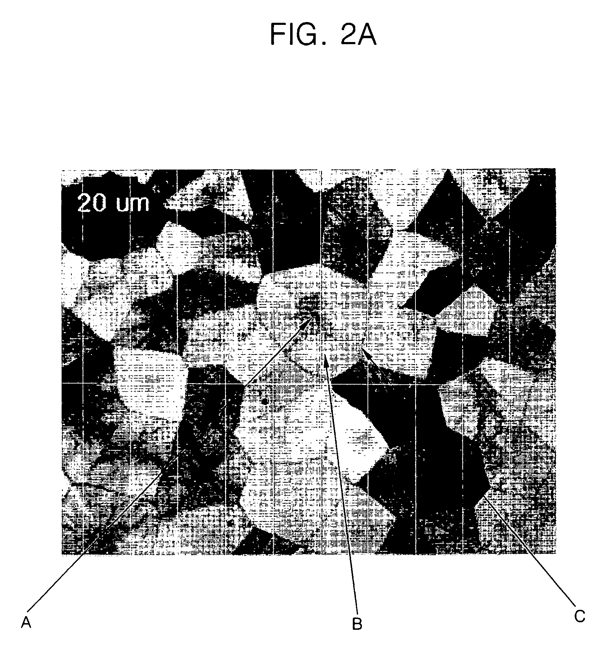

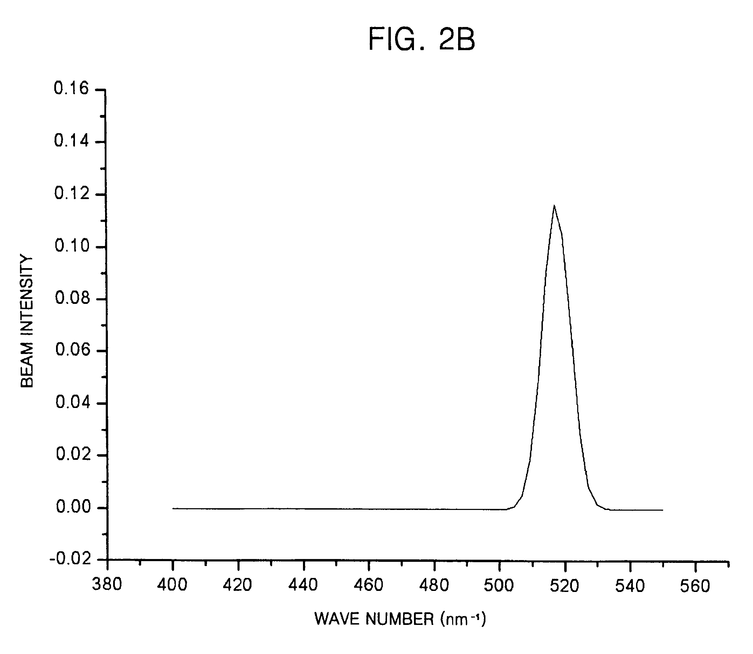

FIG. 2A is a Scanning Electron Microscope (SEM) photograph showing crystal grains of a polycrystalline silicon layer formed by an SGS method according to an embodiment of the present invention. FIGS. 2B to 2D are Raman spectrum graphs illustrating differences in crystallinity according to internal positions of the crystal grains shown in FIG. 2A.

Referring to FIG. 2A, the grains constituting the polycrystalline silicon layer 108 may be divided into a seed region A, a grain boundary region C, and a crystal growth region B.

FIGS. 2B to 2D illustrate characteristic analysis results in the crystal grain of the polycrystalline silicon layer using a general apparatus of analyzing thin film characteristics such as a Raman spectra analyzer, wherein an X-axis of the graph denotes the applied wave number (nm⁻¹) and a Y-axis of the graph denotes the beam Intensity of the measured component. The Raman spectrum measurement allows the crystallization property to be measured, which can determine its crystallinity by comparing a peak of an amorphous silicon layer with a peak of a polycrystalline silicon layer in their own wavelength ranges, and can determine that the crystallization has good quality when a ratio between the peak of the amorphous silicon layer and the peak of the polycrystalline silicon layer is higher. Meanwhile, smooth portions in the Raman spectrum graph of FIGS. 2B to 2D show amorphous components and peak portions show crystalline components.

FIG. 2B shows a Raman spectrum measurement of the crystallinity in the seed region A as a central grain portion. The seed region A has a Raman spectrum peak of 0.11 as a result of measurement.

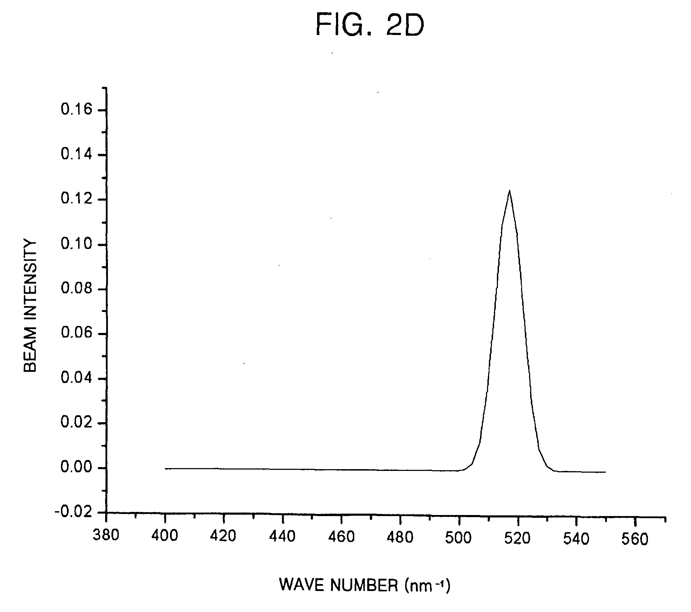

FIG. 2D shows a Raman spectrum measurement of the crystallinity in the grain boundary region C. The grain boundary region C has a Raman spectrum peak of 0.12 as a result of measurement.

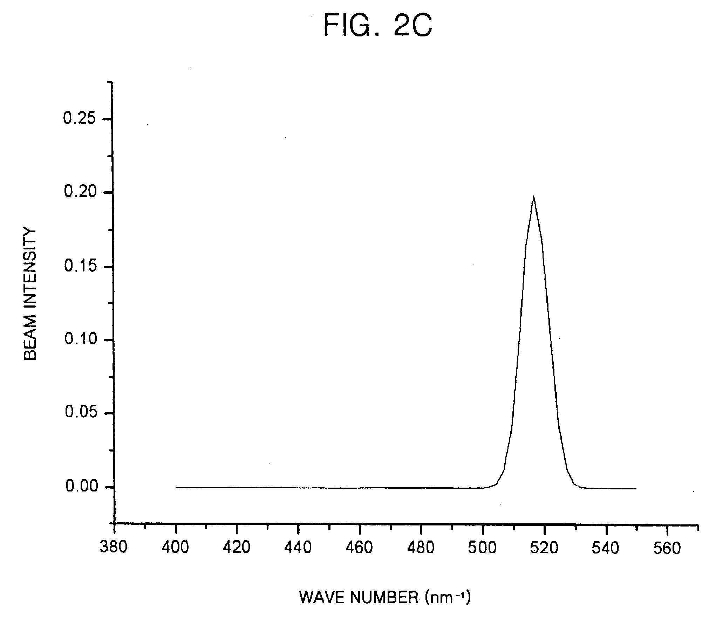

FIG. 2C shows a Raman spectrum measurement of the crystallinity in the crystal growth region B disposed between the seed region A as the central grain portion and the grain boundary region C. The crystal growth region B has a Raman spectrum peak of 0.20 as a result of measurement.

It can be calculated that crystallization fractions in the seed region A, crystal growth region B, and grain boundary region C of FIGS. 2B to 2D are 0.50, 0.60, and 0.49, respectively.

As described above, the polycrystalline silicon crystallized by SGS has three regions represented by the seed region, the crystal growth region, and the grain boundary region as seen from the Raman spectrum peaks. According to non-limiting examples, the seed region A may have a Raman spectrum peak of 0.05 to 0.11, the crystal growth region B may have a Raman spectrum peak of 0.17 to 0.24, and the grain boundary region C may have a Raman spectrum peak of 0.12 to 0.16.

Therefore, it can be found that the polycrystalline silicon crystallized by SGS is defined by three regions having different Raman spectrum peaks from each other, which is an inherent property only of the SGS method.

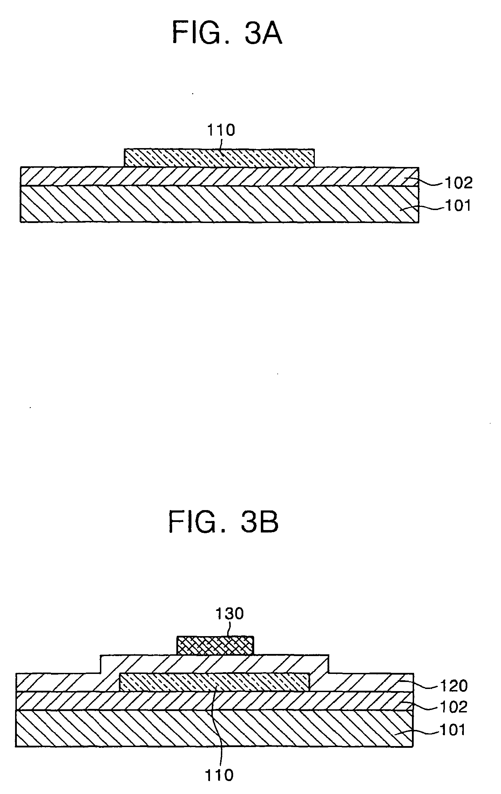

FIGS. 3A to 3D are cross-sectional views illustrating a process of fabricating a thin film transistor using a polycrystalline silicon layer fabricated according to an embodiment of the present invention.

Referring to FIG. 3A, a polycrystalline silicon layer (108 of FIG. 1D) crystallized by SGS is patterned on a substrate 101 where a buffer layer 102 is formed to form a semiconductor layer 110. Here, the semiconductor layer 110 has a small amount of remaining crystallization inducing metal due to a capping layer so that it has a leakage current characteristic superior to semiconductor layers formed by other crystallization methods.

Subsequently, as shown in FIG. 3B, a gate insulating layer 120 is formed on the substrate 101 where the semiconductor layer 110 is formed. The gate insulating layer 120 may be a single layer or a double layer formed of at least one of a silicon oxide layer and a silicon nitride layer.

Subsequently, a metal layer for a gate electrode (not shown) is formed above the gate insulating layer 120. The metal layer for the gate electrode may be a single layer formed of Al or an aluminum alloy such as aluminum-neodymium (AI-Nd) or a multiple layer where an aluminum alloy is stacked on a Cr or Mo alloy. The metal layer for the gate electrode is then etched by a photolithography process to form a gate electrode 130 in a predetermined region corresponding to the semiconductor layer 110.

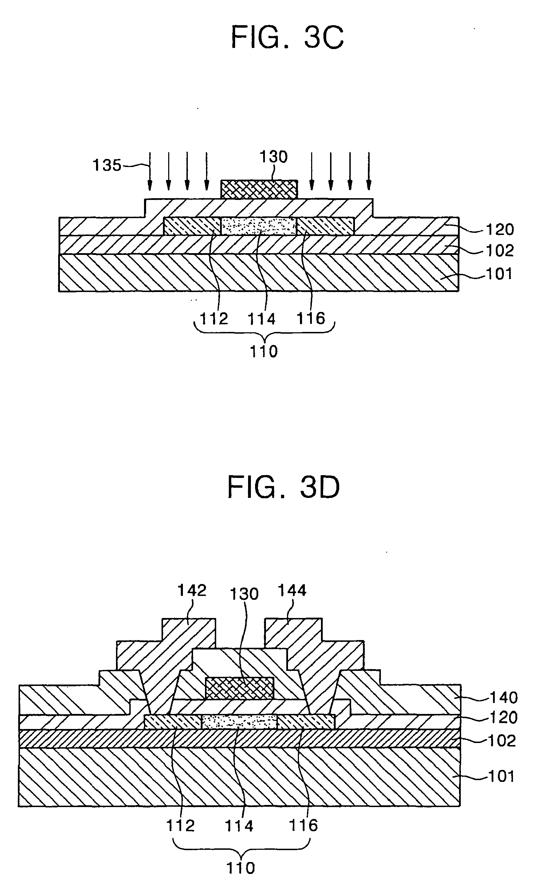

FIG. 3C is a cross-sectional view illustrating a process of implanting impurities into the semiconductor layer to form source and drain regions and a channel region. Referring to FIG. 3C, a predetermined amount of conductive impurity ions 135 are implanted using the gate electrode 130 as a mask to form a source region 112 and a drain region 116. P-type impurity ions or n-type impurity ions may be used as the impurity ions 135 for forming a thin film transistor. Here, the p-type impurity ions may be selected from the group consisting of boron (B), aluminum (AI), gallium (Ga), and indium (In), and the n-type impurity ions may be selected from the group consisting of phosphor (P), arsenic (As), and antimony (Sb).

Subsequently, as shown in FIG. 3D, an interlayer insulating layer 140 that protects the lower structures is formed above the gate electrode 130 on the gate insulating layer 120.

Subsequently, predetermined regions of the interlayer insulating layer 140 and the gate insulating layer 120 are etched to form contact holes, and a conductive layer filling the contact holes is formed and then patterned, so that predetermined regions of the semiconductor layer 110 are electrically connected to source and drain electrodes 142 and 144, thereby completing a thin film transistor.

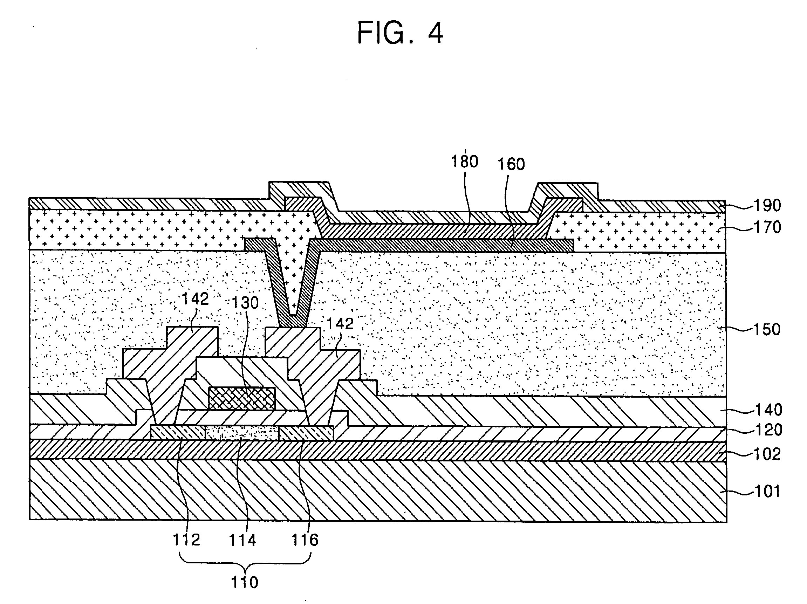

FIG. 4 is a cross-sectional view of an OLED display device according to an embodiment of the present invention.

Referring to FIG. 4, an insulating layer 150 is formed on the entire surface of the substrate 101. The insulating layer 150 may be an organic layer, an inorganic layer, or a composite layer thereof. As non-limiting examples, the insulating layer 150 may be formed of Spin-On-Glass (SOG) when it is an inorganic layer, and may be formed of an acrylic resin, a polyimidic resin, or benzocyclobutene (BCB) when it is an organic layer.

The insulating layer 150 is etched to form a via hole exposing one of the source and drain electrodes 142 and 144, and a first electrode 160 is formed to be connected to one of the source and drain electrodes 142 and 144. The first electrode 160 is disposed on the bottom of the via hole, is in contact with one of the exposed source and drain electrodes 142 and 144, and extends onto the insulating layer 150. The first electrode 160 may be formed of indium tin oxide (ITO) or indium zinc oxide (IZO).

Subsequently, a pixel defining layer 170 is formed on the entire surface of the substrate 101 including the first electrode 160. The pixel defining layer 170 has a thickness enough to fill the via hole where the first electrode 160 is disposed. The pixel defining layer 170 may be formed of an organic layer or an inorganic layer. For example, the pixel defining layer 170 may be formed of one selected from the group consisting of benzocyclobutene (BCB), an acrylic polymer, and polyimide. The pixel defining layer 170 may have good flowability so that the pixel defining layer 170 can be smoothly formed on the entire surface of the substrate.

The pixel defining layer 170 is etched to form an opening exposing the first electrode 160, and an organic layer 180 is formed on the first electrode 160 exposed through the opening. The organic layer 180 includes at least an emission layer, and may further include at least one of a hole injection layer, a hole transport layer, an electron transport layer, and an electron injection layer.

Subsequently, a second electrode 190 is formed on the entire surface of the substrate 101. The second electrode 190 is be formed of Mg, Ag, Al, Ca, or an alloy thereof. The second electrode 190 is formed to be transparent, as a transmissive electrode, and has a low work function.

Accordingly, an OLED display device according to an embodiment of the present invention is completed.

According to aspects of the present invention as described above, the degree of crystallization can be easily determined by analyzing Raman spectrum peaks of a polycrystalline silicon layer formed by an SGS method, and the polycrystalline silicon layer can be defined with a specific Raman spectrum peak.

Also, a small amount of crystallization inducing metal can remain in a semiconductor layer so that a thin film transistor having good characteristics can be fabricated.

Although a few embodiments of the present invention have been shown and described, it would be appreciated by those skilled in the art that changes may be made in this embodiment without departing from the principles of the invention, the scope of which is defined in the claims and their equivalents.

## Claims

1. A thin film transistor, comprising:
a substrate;
a semiconductor layer disposed on the substrate, including a source region, a drain region and a channel region, and made of polycrystalline silicon;
a gate electrode disposed to correspond to a predetermined region of the semiconductor layer;
a gate insulating layer disposed between the semiconductor layer and the gate electrode; and
source and drain electrodes electrically connected to the source and drain regions of the semiconductor layer, respectively,
wherein the polycrystalline silicon layer comprises a plurality of regions having different Raman spectrum peaks from each other.

2. A thin film transistor according to claim 1, wherein the plurality of regions of the polycrystalline silicon layer comprise a seed region, a grain boundary region, and a crystal growth region disposed between the seed region and the grain boundary region.

3. A thin film transistor according to claim 2, wherein the seed region has a Raman spectrum peak of 0.05 to 0.11.

4. A thin film transistor according to claim 2 or 3, wherein the crystal growth region has a Raman spectrum peak of 0.17 to 0.24.

5. A thin film transistor according to claim 2, 3 or 4, wherein the grain boundary region has a Raman spectrum peak of 0.12 to 0.16.

6. A thin film transistor according to one of Claims 2 to 5, wherein the seed region comprises a crystallization inducing metal.

7. A thin film transistor according to claim 6, wherein the crystallization inducing metal comprises at least one material selected from the group consisting of Ni, Pd, Ti, Ag, Au, Al, Sn, Sb, Cu, Co, Mo, Tr, Ru, Rh, Cd, and Pt.

8. A method of fabricating a thin film transistor, comprising:
preparing a substrate;
forming an amorphous silicon layer on the substrate;
forming a capping layer on the amorphous silicon layer;
forming a metal catalyst layer on the capping layer;
annealing the substrate, diffusing the metal catalyst onto the amorphous silicon layer through the capping layer, and crystallizing the amorphous silicon layer into a polycrystalline silicon layer composed of a plurality of regions having different Raman spectrum peaks from each other;
removing the capping layer and the metal catalyst layer;
patterning the polycrystalline silicon layer to form a semiconductor layer;
forming a gate insulating layer on the semiconductor layer;
forming a gate electrode on the gate insulating layer;
forming an interlayer insulating layer on the gate electrode; and
etching the interlayer insulating layer and the gate insulating layer, and forming source and drain electrodes electrically connected to predetermined regions of the semiconductor layer.

9. A method according to claim 8, wherein the plurality of regions of the polycrystalline silicon layer comprise a seed region, a grain boundary region, and a crystal growth region disposed between the seed region and the grain boundary region.

10. A method according to claim 9, wherein the seed region has a Raman spectrum peak of 0.05 to 0.11.

11. A method according to claim 9 or 10, wherein the crystal growth region has a Raman spectrum peak of 0.17 to 0.24.

12. A method according to claim 9, 10 or 11, wherein the grain boundary region has a Raman spectrum peak of 0.12 to 0.16.

13. A method according to one of Claims 8 to 12, wherein the annealing is performed at a temperature of 200°C to 900°C.

14. A method according to one of Claims 8 to 13, wherein the metal catalyst comprises at least one material selected from the group consisting of Ni, Pd, Ti, Ag, Au, Al, Sn, Sb, Cu, Co, Mo, Tr, Ru, Rh, Cd, and Pt.

15. A method according to one of Claims 8 to 14, wherein the metal catalyst is formed with a surface density of 10¹¹ atoms/cm² to 10¹⁵ atoms/cm².

16. An organic lighting emitting display device (OLED), comprising:
a thin film transistor according to one of Claims 1 to 7;
a first electrode connected to the source and drain electrodes;
an organic layer disposed on the first electrode; and
a second electrode disposed on the organic layer.
